# EUROPEAN PATENT APPLICATION

(11) **EP 3 309 948 A1**
(43) Date of publication of application: **18.04.2018**
(21) Application number: 17184920.1
(22) Date of filing: 04.08.2017
(51) Int. Cl.: H02M 3/156, H01L 29/16, H02M 3/158

(54) **A DC-DC HYBRID CONVERTER WITH GALLIUM NITRIDE AND SILICON TRANSISTORS**

(30) Priority: 14.10.2016 IN 201641035195
(71) Applicant: Indian Institute of Science, Bangalore, Karnataka 560012 (IN)
(72) Inventor: Hedayati, Mohammad Hassan, 560012 Karnataka (IN); John, Vinod, 560012 Karnataka (IN)
(74) Representative: Vossius & Partner Patentanwälte Rechtsanwälte mbB

(57) **Abstract**

The present invention provides a hybrid combination of GaN transistor and Si transistor that are connected in an unique manner in a synchronous DC-DC power converter. The GaN transistor acts as active switch and the Si transistor acts as synchronous diode to reduce the power loss in a DC-DC power converter.

## Description

The present invention relates to the field of electronics. More specifically the invention relates to DC-DC power converters. The present invention provides a unique hybrid configuration of transistors; Gallium nitride and Silicon transistors to increase the efficiency of the power converter by minimizing the power loss. The DC-DC converter employs Gallium nitride transistor as active switch and silicon transistor as synchronous diode to minimize the power loss.

DC-DC converters are widely used in a large number of electronic applications. A DC-DC converter converts a direct current input voltage to a different direct current output voltage and outputs the direct current output voltage to a load. A DC-DC converter is included in each electronic circuit operating with different direct current voltages in various electronic products to convert an input voltage to a stable direct current voltage and outputs the direct current voltage as required. Solid state switches are used in power converters to switch the voltage and current to ON and OFF states, and to achieve desired output voltage or current.

Various topologies are suggested in literature to reduce the size and the cost, as well as increasing the efficiency of a power converter. DC-DC converters with Silicon (Si) transistors are well developed and mature. Si transistors such as MOSFETs are widely used in power converters. However, when compared to newer devices made of material such as GaN, Si based devices have some disadvantage. GaN devices can switch very fast in the range of MHz and help in reducing the transition time during turn-on and turn-off. Reduced turn on/off times reduces the transition losses that leads to higher power conversion efficiency. This reduces the filter passive filtering components, L and C, and makes the converter compact.

However, the technology of GaN devices is still young and needs some improvement. Further, GaN devices have some disadvantage compared with Si transistors, such as lossy operation in reverse current conduction conditions.

Use of parallel power converters with interleaved PWM is explained in "Modified Discontinuous PWM for Size Reduction of the Circulating Current Filter in Parallel Interleaved Converters ", IEEE Transactions on Power Electronics; Vol.30., No 7,2015. In this method converters are connected in parallel and the method cannot be used in the case where a single converter is needed. In "A 10-MHz GaN HEMT DC/DC Boost Converter for Power Amplifier Applications", IEEE Transactions on Circuits and Systems; Vo159, No.11, 2012, a 10-MHz GaN transistor based DC-DC boost converter for power amplifier applications is proposed. Usage of GaN switching devices can increase the overall efficiency. However, it is noticed that the conduction in the reverse direction of the GaN switching device is more lossy than in a Si transistor.

The present invention aims to address the loss in DC-DC power converters by providing a unique combination of Gallium Nitride and Silicon transistors. It is advantageous to use Silicon transistor as the synchronous diode while Gallium Nitride transistor is used as active switch to increase the overall power converter efficiency.

Accordingly the present invention is in relation to a DC-DC power converter; comprising a circuit with Gallium nitride transistor as an active switch, a Silicon transistor as synchronous diode and passive elements to control the power loss; and a method of fabrication of DC-DC power converter comprising a circuit with Gallium nitride transistor as an active switch, a Silicon transistor as synchronous diode and passive elements to provide filtering, said method comprising connecting a Gallium nitride transistor to the input voltage in series to a Silicon transistor and passive elements to form a circuit; and a DC-DC power converter, wherein multiple power converter of present invention are connected in parallel.

### BRIEF DESCRIPTION OF FIGURES

The features of the present invention can be understood in detail with the aid of appended figures. It is to be noted however, that the appended figures illustrate only typical embodiments of this invention and are therefore not to be considered limiting of its scope for the invention.
Figure 1: DC-DC buck converter; (a) Normal converter and (b) Buck converter.
Figure 2: shows different configurations of the Si and GaN transistors.
Figure 3: shows percentage power loss of the four possible converter combinations as a function of loading condition. This is done at four input voltages (a) Vin = 6V (low), (b) Vin = 10V (medium-low), (c) Vin = 15V (medium -high), (d) Vin = 20V (High).
Figure 4: shows efficiency in percentage versus load power for the four synchronous buck converter configurations. The plot is shown for four conditions of input voltage from lower (6V) to high (20V) values. It can be observer that for loading conditions close to the rated load condition, the proposed configuration leads to the highest efficiency.
Figure 5: Temperature of the Q1 and Q2 transistor of the synchronous buck converter as a function of loading condition. This is done at four input voltages (a) Vin = 6V (low), (b) Vin = 10V (medium-low), (c) Vin = 15V (medium-high), (d) Vin = 20V (High).
Figure 6: shows photograph of a typical DC-DC power converter fabricated to study the various parameters associated with the present invention.
Figure 7: shows a schematic diagram of a typical DC-DC power converter with Si, GaN transistors and passive elements.

### DETAILED DESCRIPTION OF INVENTION

The foregoing description of the embodiments of the invention has been presented for the purpose of illustration. It is not intended to be exhaustive or to limit the invention to the precise form disclosed as many modifications and variations are possible in light of this disclosure for a person skilled in the art in view of the Figures, description and claims. It may further be noted that as used herein and in the appended claims, the singular "a" "an" and "the" include plural reference unless the context clearly dictates otherwise. Unless defined otherwise, all technical and scientific terms used herein have the same meanings as commonly understood by person skilled in the art.

The present invention is in relation to a DC-DC power converter; comprising a circuit with Gallium Nitride transistor as an active switch, a Silicon transistor as synchronous diode and passive elements to provide filtering.

In an embodiment of the present invention, the power converter is a synchronous power converter.

In another embodiment of the present invention, the power converter is a buck converter.

In still another embodiment of the present invention, the power converter is a boost or a buck boost power converter.

The present invention is in relation to a method of fabrication of a DC-DC power converter of present invention said method comprising connecting a Gallium Nitride transistor to the input voltage in series to a Silicon transistor and passive elements to form a circuit.

In still another embodiment of the present invention, the Gallium Nitride transistor acts as active switch.

In yet another embodiment of the present invention, the Silicon transistor acts as synchronous diode.

The present invention is also in relation to a DC-DC power converter, wherein multiple power converter of the present invention are connected in parallel.

In still another embodiment of the present invention, the parallel power converters are operated in an interleaved manner.

The present invention provides a unique hybrid combination of Gallium nitride (GaN) transistor and Silicon (Si) transistor in a DC-DC converter to minimize the loss of power in a DC-DC buck converter. It is established that the use of GaN transistors for the active switch and Si transistor for the synchronous diode minimizes the power loss, thus resulting in higher efficiency than pure GaN or Si transistor based power converters.

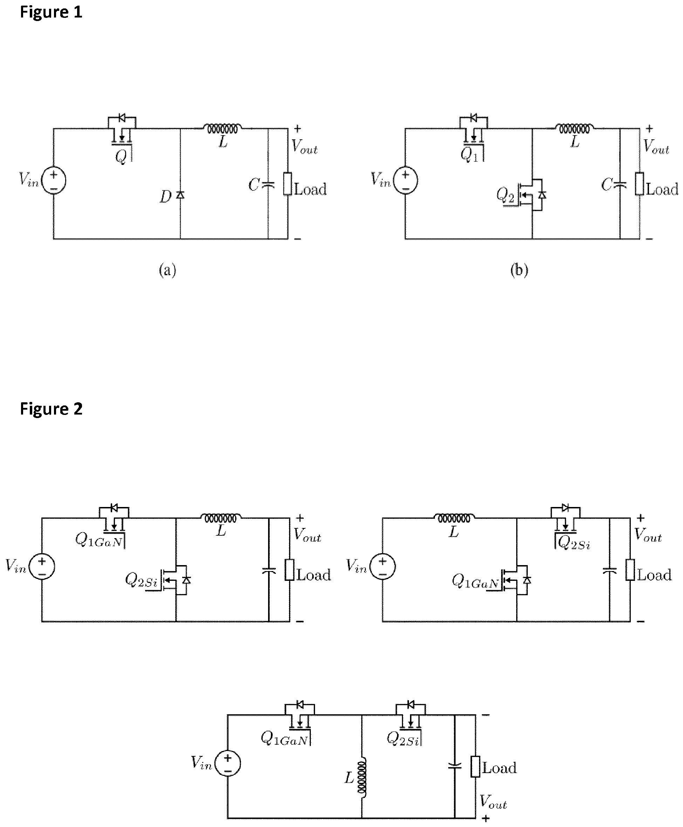

An efficient way of converting a DC voltage to a lower DC voltage is to use a DC-DC buck converter. In a normal DC-DC buck converter, an active switch and a diode along with the passive components, inductor L and capacitor C, are used to switch the current and reduce the voltage level to a desired voltage level. It is possible to enhance the efficiency of normal dc-dc buck converter by adopting an active switch MOSFET in place of the diode. This is due to the lower voltage drop across the MOSFET compared to the diode while conducting current. This configuration is called synchronous DC-DC buck converter and is shown in Figure 1(b), while the active switch and diode typically made of Si material is shown in Figure 1(a).

In synchronous power converters, the synchronous diodes conduct in reverse direction most of the time. However, the active switches conduct in forward direction most of the time and hence, the usage of GaN devices is advantageous. Hence, the present invention proposes the usage of GaN devices as active switches and Si devices as synchronous diodes in a synchronous power converter to improve the overall efficiency of the power converter. This is because lower losses also lead to lesser temperature rise above ambient, which result in higher reliability of the proposed synchronous buck converter.

The present invention offer capability to switch faster and with lower conduction voltage drop. The converters are tested at different operating condition and the results are compared with each other. It is shown that the proposed hybrid configuration of Si and GaN transistors, is more efficient at rated power, than other possible configurations.

The switches in the buck converter can operate at high frequency in the range of hundreds of kHz to MHz. The operation at higher switching frequency can reduce the size and cost of the LC filter components.

A synchronous buck converter consisting of two switches Q1 and Q2 as shown in Figure 2. This along with two transistor technologies (GaN and Si based transistor technologies) there are four possible different device combinations, as mentioned in Table 1. The converter with all Si devices is what corresponds to existing mature technology. GaN transistor based synchronous buck converters is an emerging technology based on novel GaN material that has become available recently. The unique combination of GaN and Si transistors as indicated in Table I (GaN-T-Si-B), results in the most efficient synchronous buck converter. The subscripts T and B corresponds to transistor Q1 and Q2 as in Figure 1, respectively.

**Table 1: Details of the converter configuration**

| **Configuration** | **Comment** |
|---|---|
| Si_{T} Si_{B} | Si converter with both Si switches |
| GaN_{T} GaN_{B} | GaN converter with both GaN switches |
| Si_{T}GaN_{B} | Hybrid converter with Si as active switch and Gan as synchronous rectifier switch |
| GaN_{T}Si_{B} | Most efficient hybrid converter with GaN as active switch and Si as synchronous rectifier switch |

The aforesaid four configurations were studied for power loss, efficiency and lower transistor temperature.

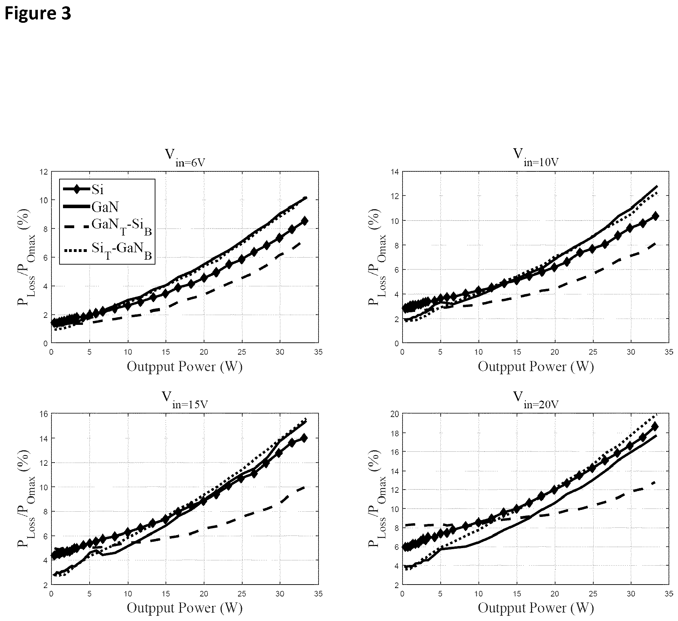

Figure 3 shows the power loss in percentage versus load power for the aforementioned four synchronous buck converter configurations. This is measured for four conditions of input voltage from lower (6V) to high values (20V). It is observed that for loading conditions close to the rated value, the proposed configuration leads to the lowest power dissipation. The blue line in the bottom in the plots indicates the lower power loss due to present configuration of transistors of the present invention.

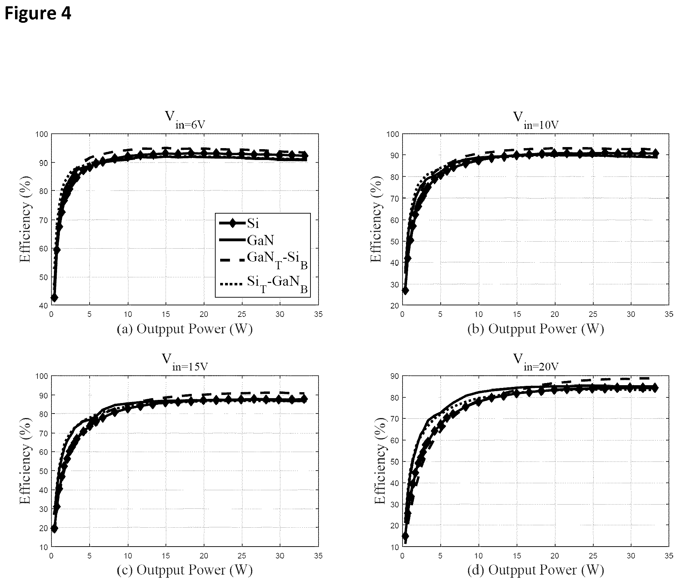

Figure 4 shows efficiency in percentage versus load power for the four synchronous buck converter configurations. The plots is shown for four conditions of input voltage from lower (6V) to high (20V) values. It can be observed that for loading conditions close to the rated load condition, the proposed configuration leads to the highest efficiency.

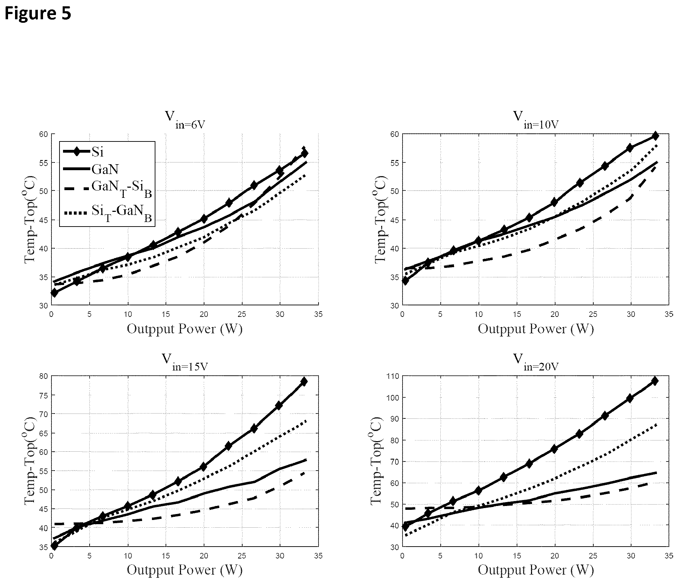

Figure 5 show temperature in degrees of the upper transistor Q1 versus load power for the synchronous buck converter configurations. Figure 5 shows a similar plot for the lower transistor Q2 of the synchronous buck converter. The plots are also shown for four conditions of input voltage, from lower (6V) to high values (20V). It can be observed that for the range of loading conditions and input voltages the temperature of transistors Q1 stays below 57 °C in the proposed configuration, while that in a Si converter the temperature goes as high as 108 °C, while the corresponding value is above 60 °C for a GaN converter. Similarly the temperature of transistor Q2 stays below 72 °C for the proposed configuration while that for the Si converter reaches 62 °C and the GaN converter reaches close to 88 °C. Hence, the proposed topology has operating temperature for Q1 and Q2 closer to its nominal value resulting in increased reliability of the overall converter, without under-utilizing any of the switches. The blue line indicates the temperature rise of the proposed configuration does not exceed 72 °C under all the operating conditions.

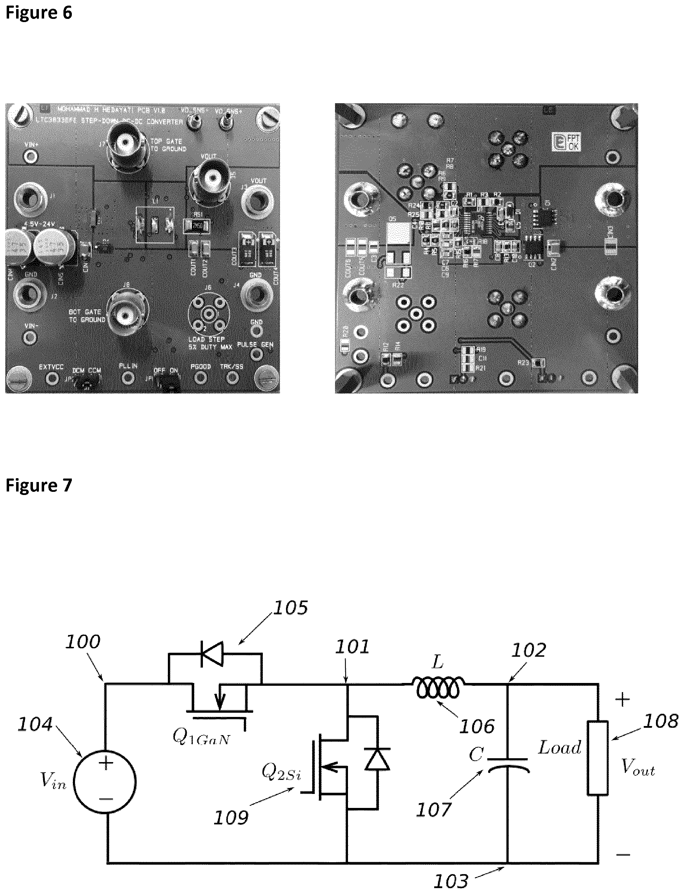

Further, the typical DC-DC power converter fabricated to study the various parameters associated with the the present invention is shown in figure 6. The details of transistors and other passive elements used in the converter is listed in the Table 2

**Table 2**

| DETAILS OF THE FABRICATED SYNCHRONOUS BUCK CONVERTER | |
|---|---|
| Configuration | Comment |
| Si switch | Si4456dy, 40 V, 33 A |
| GaN switch | EPC-GaN-2015, 40 V, 33 A |
| Inductor | SRN4026-1ROY, *µ*H, 24 A |
| Filter Capacitor | Tantalum - 6TPC330MA, 2×330 *µF,* 6.3 *V* |
| | Ceramic - GRM31CR60J107ME39L, 2×100 *µF,* 6.3 *V* |
| Controller | LTC3833 |
| *Vᵢₙ* | 6-20 V |
| *Vₒᵤₜ* | 3.3 V |
| *Iₒᵤₜ* | 1.0 A |
| *F_{sw}* | 1 MHz |

### METHOD OF FABRICATION OF THE BUCK CONVERTER FOCUSING OF THE CONNECTIVITY OF THE TRANSISTORS AND PASSIVE ELEMENTS:

In a typical synchronous buck converter the input voltage source 104 is connected between nodes 100 and 103. The active switch 105 is connected between nodes 100 and 101. The active switch 105, the synchronous diode 109, and output filter inductor 106 are connected together at node 101. The synchronous diode is connected between nodes 101 and 103. The output filter consists of a filter inductor 106 and capacitor 107 connected in an LC low pass configuration. The inductor 106 is connected between nodes 101 and 102, while capacitor 107 is connected between nodes 102 and 103. Capacitor 107 may consist of multiple capacitors connected effectively in parallel. Similarly, inductor 106 may consist of multiple inductors connected effectively in parallel. The output voltage is obtained between nodes 102 and 103, and the load 108 can be connected across these nodes. In the preferred embodiment of this invention, the transistor 105 is a Gallium Nitride device while the synchronous diode 109 is a Si transistor (Figure 7)

The reason for the higher efficiency of the proposed circuit configuration is the superior reverse conduction characteristics of the Si MOSFET and the superior switching and forward conduction and switching characteristics of the GaN HEMT which is combined together in the proposed hybrid configuration.

The present invention thus provides synchronous buck power converters varying from 3W to 500 kW, with input voltage levels of 10V to 1000V.

Multiple DC-DC converters of the present invention can also be efficiently connected in parallel to operate in an interleaved manner.

Thus the hybrid combination of the present invention, i.e., GaN active switch and Si synchronous diode helps in improving the efficiency of the synchronous buck converters in an economical way.

## Claims

1. A DC-DC power converter; comprising a circuit with Gallium Nitride transistor as an active switch, a Silicon transistor as synchronous diode and passive elements to provide filtering.

2. The DC-DC power converter as claimed in claim 1, wherein the power converter is a synchronous power converter.

3. The DC-DC power converter as claimed in claim 1, wherein the power converter is a buck converter.

4. The DC-DC power converter as claimed in claim 1, wherein the power converter is, a boost or a buck boost power converter.

5. A method of fabrication of DC-DC power converter, in particular as claimed in any one of claims 1 to 4, said method comprising connecting a Gallium Nitride transistor to the input voltage in series to a Silicon transistor and passive elements to form a circuit.

6. The method as claimed in claim 5, wherein the Gallium Nitride transistor acts as active switch.

7. The method as claimed in claim 5 or 6, wherein the Silicon transistor acts as synchronous diode.

8. A DC-DC power converter, wherein multiple power converter of any one of claims 1 to 4 are connected in parallel.

9. The DC-DC power converter as claimed in claim 8, wherein the parallel power converters are operated in an interleaved manner.
